Europäisches Patentamt

European Patent Office

Office européen des brevets

(19)

(11) Publication number: **0 074 680**
**B1**

(12)

# EUROPEAN PATENT SPECIFICATION

(45) Date of publication of patent specification: **08.01.86**

(51) Int. Cl.⁴: **H 03 F 3/45**

(21) Application number: **82201050.0**

(22) Date of filing: **20.08.82**

(54) **Differential amplifier.**

(30) Priority: **24.08.81 US 295433**
**20.07.82 US 400199**

(43) Date of publication of application:
**23.03.83 Bulletin 83/12**

(45) Publication of the grant of the patent:
**08.01.86 Bulletin 86/02**

(84) Designated Contracting States:
**AT DE FR GB IT NL SE**

(56) References cited:
**US-A-4 284 957**

**IEEE INTERNATIONAL SOLID-STATE CIRCUITS
CONFERENCE DIGEST OF TECHNICAL
PAPERS, 17th February 1978, pages 232-233,
Lewis Winner, Coral Gables (USA); R.A.
BLAUSCHILD: "High-voltage analog
performance from low-voltage digital devices"**

**ELECTRICAL DESIGN NEWS, vol. 20, no. 1,
January 1975, pages 37-38, Denver (USA); T.A.
HAMILTON: "Current op amp has limitless
potential"**

(73) Proprietor: **International Standard Electric
Corporation
320 Park Avenue
New York New York 10022 (US)**

(72) Inventor: **Pernyeszi, Joseph
43 Mayflower Circle
Fairfield, Conn. (US)**

(74) Representative: **Vermeersch, Robert et al
BELL TELEPHONE MANUFACTURING
COMPANY Naamloze Vennootschap Patent
Department Francis Wellesplein 1
B-2000 Antwerp (BE)**

(56) References cited:

**IBM TECHNICAL DISCLOSURE BULLETIN, vol.
18, no. 6, November 1975, pages 1695-1696,
New York (USA); R.C. JAEGER: "High-
performance input stage for integrated
operational amplifiers"**

Courier Press, Leamington Spa, England.

## Description

The present invention relates to a differential amplifier with two signal branches each connected in series with a common current source between terminals of a power supply source and each having a signal input.

Such a differential amplifier is known from US patent 4 284 957. If it should be able to operate with or withstand a relatively high supply voltage, e.g. above 200 Volts following use in a telephone line circuit where such magnitudes can be encountered with ringing signals, each of the two series circuits formed by a signal branch and the common current source should include high voltage devices, such as transistors, to withstand such a high supply voltage. On the other hand, in order that such an amplifier should be able to withstand high voltage common mode signals applied to its inputs such high voltage devices should also be present in each of the two series circuits formed by the part of a signal branch extending between an input and the power supply terminal to which the common source is connected. This is the reason why in general most of the devices such as transistors used in differential amplifiers able to withstand high voltage must individually also exhibit such a property.

A drawback of the use of high voltage transistors, especially in differential or operational amplifiers where the two signal branches have to be closely matched, is that their manufacturing accuracy, i.e. their quality, is lower than that of low voltage transistors which in integrated form moreover require less silicon area.

An object of the present invention is to provide a differential or operational amplifier of the above type but which although able to withstand high voltage input signals permits a substantial number of low voltage devices to be retained.

According to the invention this object is achieved due to the fact that each of said signal branches and an associated parallel signal branch have a common portion constituted by the base-to-emitter junction of a respective high voltage transistor whose base constitutes a respective signal input and whose collector is coupled to one of said power supply terminals, said parallel signal branch having a low signal impedance as compared to that of said current source and being able to establish a substantially constant voltage between each of said inputs and the junction point of said branches and said current source.

Thus, when a common mode voltage signal for instance is applied to the input of the amplifier, the constant voltage then established by the parallel signal branch also appears across a part of the associated signal branch extending between an amplifier input and the junction point. Therefore, even when a high voltage input signal is applied, these parts of the signal branches do not require the use of a high voltage device, the latter being only required in the current source.

Another characteristic feature of the present differential amplifier is that said current source includes a third high voltage transistor.

Thus, using only a total of three high voltage transistors this amplifier is now able to withstand not only high voltage input signals but also a high supply voltage.

Still another characteristic feature of the present differential amplifier is that in each of said parallel signal branches said base-to-emitter junction is connected in series with diodes.

As will be later described, such diodes will advantageously be realised by the emitter-base junctions of low voltage transistors.

It should be noted that the article "Current op amp has limitless potential" by T. A. Hamilton, published in Electrical Design News, Vol. 20, No. 1, January 1975, pp. 37—38, disclose a differential amplifier including a low impedance branch constituted by diodes and coupled between input transistors and a common current source. But this branch is used to suitably bias these input transistors.

The above mentioned and other objects and features of the invention will become more apparent and the invention itself will be best understood by referring to the following description of embodiments taken in conjunction with the accompanying drawings in which:

Fig. 1 is a circuit diagram of a first embodiment of an operational amplifier according to the invention; and

Fig. 2 is a circuit diagram of a second embodiment.

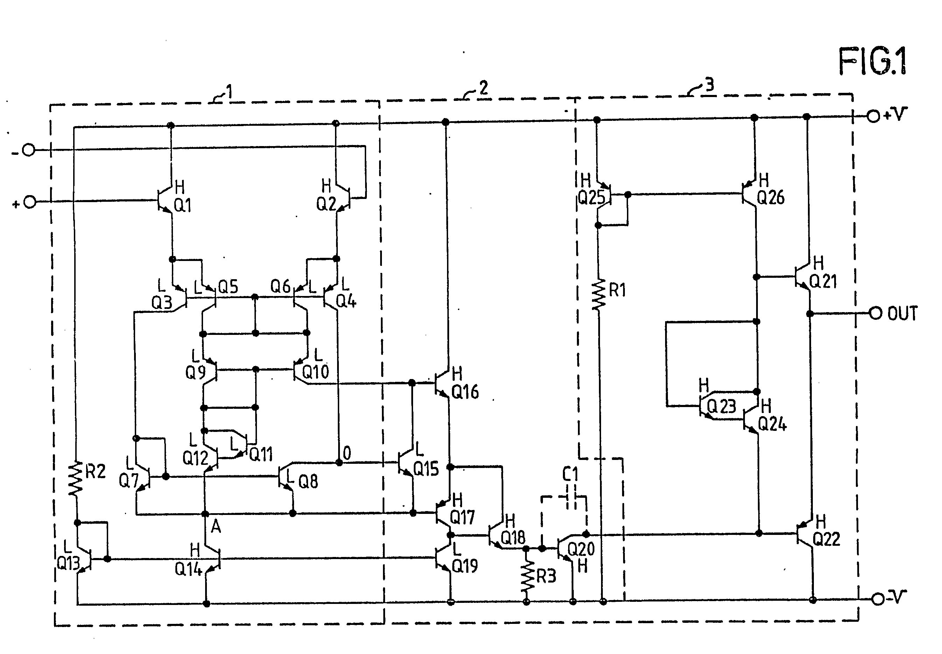

The operational amplifier illustrated in Fig. 1 is fed from a power supply source, e.g. terminals +V and −V. The design of the amplifier is such that it can be used in circumstances where the voltage supplied by this source may far exceed what is sufficient for its proper operation. The potential difference may for instance be larger than 200 Volts, created by the application of ringing current as a result of the amplifier being included in a telephone line circuit. It includes an input stage 1, an intermediate stage 2 and an output stage 3. Input stage 1 has an inverting input designated by − and a non-inverting input indicated by +, and output stage 3 has an output OUT.

To withstand successfully such high potential difference between the terminals +V and −V, input stage 1 includes first of all high voltage NPN transistors Q1 and Q2 which are used in emitter follower configuration. Their collectors are both connected to +V, their bases to the inputs + and − respectively, and their emitters to those of the pair of low voltage double collector PNP lateral transistors Q3/Q5 and Q4/Q6 respectively. The bases of the transistors Q3/Q5 and Q4/Q6 as well as the collectors of Q5 and Q6 are interconnected so that these last two transistors act as diodes. Thus, the pairs of transistor Q3/Q5 and Q4/Q6 are each connected in current mirror configuration. The collector of transistor Q3 is connected to the collector of diode connected low voltage NPN transistor Q7, and the collector of transistor Q4 is connected to the collector of low voltage NPN transistor Q8 the base of which is connected to that of transistor Q7, the emitters of Q7 and Q8 being connected at A. Transistors Q7 and Q8 are thus also connected in current mirror configuration and form an active load for the transistors Q3 and Q4. The collector of Q8 constitutes the output O of the input stage 1 which is biased by the current source including NPN transistors Q13 and Q14, connected in current mirror configuration, as well as resistor R2. The latter transistor Q14 is a high voltage transistor whose collector is connected to the common junction point A of the emitters of Q7 and Q8 and whose base is connected to that of low voltage transistor Q13 as well as to the collector thereof which is coupled to +V through resistor R2, the emitters of Q13 and Q14 being connected to −V.

The collectors and bases of the diode connected transistors Q5 and Q6 are coupled via an active load, comprising the low voltage PNP transistors Q9 and Q10, to the collector of low voltage NPN transistor Q15. Transistor Q9 is diode connected as shown, with its base coupled to that of transistor Q10 in current mirror configuration and the collectors of Q9 and Q10 are connected to those of Q11/Q12 and Q15 respectively. The collectors and bases of both transistors Q9 and Q11 are interconnected so that with the emitter of Q11 connected to the base of Q12, two series connected forward biased diode junctions are present between the common base of Q9/Q10 and the above mentioned common junction point A to which the emitters of Q12 and Q15 are connected.

Transistor Q15 whose base is connected to the O terminal, i.e. the output of the input stage (collector of Q8), is part of the intermediate stage 2 acting as a level shifter transducer and driver. The collector output of Q15 and the junction point A are connected to its input terminals and it includes the high voltage transistors Q16, Q17 and Q18. Thus, it provides for the transformation of a floating signal appearing across the transducer input terminals, i.e. the bases of Q16 and Q17, to a non-floating signal appearing across the transducer output terminals, one of which is constituted by the power supply source terminal −V and the live one by the emitter of Q18. The collector of NPN transistor Q16 is connected to +V and its emitter is connected to the emitter of Q17 which is a high voltage lateral PNP transistor the collector of which is connected to the base of NPN transistor Q18 whose collector is connected to the emitter of Q17. Transistor Q16 is an emitter follower providing impedance transformation from the collector of Q15 to the emitter of Q17. Transistor Q18 on the other hand is used to improve the beta current amplification factor of transistor Q17. Composite transistor Q17, Q18 has a beta factor which is the product of the individual ones of Q17 and Q18, but still operates as a PNP transistor and has a relatively small cutoff frequency. The emitter output of Q18 which constitutes the live output terminal of the transducer is biased to the −V reference potential via resistor R3. The base of Q18 is connected to −V via the collector-emitter path of low voltage NPN transistor Q19 which, like Q14, is connected in current mirror configuration with transistor Q13. However, Q19 is built with a small emitter so that its collector current is only a small fraction of the collector current of Q14. The emitter of transistor Q18 is connected to the base of high voltage NPN transistor Q20 the emitter of which is connected to −V and the collector of which is connected to the output stage 3 for which transistor Q20 constitutes the drive transistor.

This output stage 3 includes high voltage NPN transistor Q21 and high voltage PNP transistor Q22 the emitter-collector paths of which are connected in series between +V and −V as shown, and the bases of which are interconnected by the crossover reducing forward biased diode junctions provided by the high voltage NPN transistors Q23 and Q24 which are interconnected as shown. The output stage is biased by the current source comprising resistor R1 and diode connected high voltage PNP transistor Q25 which are serially connected between +V and −V as shown. The base of transistor Q25 is connected to the base of high voltage current mirror PNP transistor Q26 the emitter of which is connected to +V and the collector of which is connected to the base of Q21. That of Q22 is connected to the collector of the high voltage NPN drive transistor Q20.

From the above it follows that the input stage includes two signal branches Q1, Q3, Q7 and Q2, Q4, Q8 each connected in series with a common current source Q14 between the terminals +V and −V of a power supply source and each having a signal input + and − respectively. Between each of these signal inputs and the common source a parallel signal branch is connected which includes the base-emitter junctions of transistors Q1 and Q2 respectively, in series with those of Q5/6, Q9/10, Q11 and Q12, each such parallel signal branch comprising five such diodes in series; having thus a low impedance when compared with that of the current source.

Only the transistors Q1, Q2 and Q14 are high voltage transistors in order that the input stage should be able to operate with or withstand the above mentioned high supply voltage which may be larger than 200 Volts.

On the other hand, transistors Q3, Q7 and Q4, Q8 of the signal branches Q5, Q6 and Q9, Q10, Q11, Q12 of the parallel signal branches can be low voltage transistors because in this way a voltage equal to the sum of four emitter-base voltages is established between the emitters of Q1/2 and the junction point A so that between each signal input and point A this voltage is equal to five emitter-base voltages, as already mentioned. Hence, when a common mode signal is applied to the amplifier inputs the voltage across the part of the signal branches located between an amplifier input and the junction point A remains constant whilst the voltage at this common junction point A varies in function of the magnitude of this signal. This is another reason why Q14 has to be a high voltage transistor.

When such a common mode signal is applied, the currents in the branches Q3, Q7; Q4, Q8; Q5/Q6, Q9, Q11/Q12 and Q5/Q6, Q10, Q15 of the input stage remain substantially constant independently of the magnitude of this signal. Indeed, the collector currents of Q3 and Q4 are substantially the same, say I, neglecting also the base current of Q15, because of the current mirror configuration of Q7 and Q8. Similarly, because of the current mirror configuration of Q3 to Q6 the collector currents of Q5 and Q6 are also substantially equal to I, this current flowing to point A through the diode connected transistors Q11 and Q12. Finally, because Q9 and Q10 are also connected in current mirror configuration their collector currents are also substantially equal to I. Hence, when neglecting the base current of transistor Q16 the collector current of Q15 is also substantially equal to I, i.e. one fourth of that supplied by the current source including Q14.

When a differential voltage signal is applied to the amplifier, this signal has no influence on the voltage of the floating junction point A but a corresponding output signal now appears between the collector and the emitter of Q8. In the intermediate stage 2 this signal is amplified by Q15 the collector of which is connected to the active load Q9, Q10. The amplified voltage thus created across transistor Q15 is applied between the above mentioned transducer input terminals i.e. between the bases of the interconnected high voltage transistors Q16 and Q17 which amplify the floating signal appearing across Q15 and transform it into a non-floating level shifted signal which is provided between the transducer output terminals, i.e. at the emitter of Q18. This signal is then further amplified by transistor Q20.

As mentioned above, the diode connected transistors Q11 and Q12 allow junction point A to vary with the common mode input signal. Two such diodes in series are required in order to allow the correct operation of transistor Q10. Indeed, its collector being connected to point A via the base-emitter junctions of Q16 and Q17 in series, it is necessary to connect the base of transistor Q10 to point A also at least via two such diodes. Considered differently, the diode connected transistors Q11 and Q12 also ensure that, via Q10, a suitable bias voltage is applied across the bases of transistors Q16 and Q17 to allow the operation thereof.

The above mentioned output signal of transistor Q20 drives the class B output stage the operation of which will however not be described as this is without importance for the present invention and well known from pages 300—308 of the book "Analysis and design of analog integrated circuits" by P. R. Gray and R. G. Meyer, 1977, published by J. Wiley and Sons. This book also discloses on page 333 an input stage including transistors corresponding to Q1 to Q4, Q7 and Q8.

In the present amplifier, the path followed by a signal applied to an input flows via input stage 1, transistors Q17, Q18, Q20 of the intermediate stage 2, and the output stage 3 to the output OUT of the amplifier. Thus Q17 is the only high voltage (PNP) lateral transistor which is included in this signal path. From page 59 of the book "Analog integrated circuit design" by A. R. Grebene, 1972, published by Van Nostrand, Reinhold Company, it follows that the cutoff frequency or frequency at unity gain of a lateral transistor is relatively small when compared with that of a vertical (NPN) transistor. This cutoff frequency is even smaller for a high voltage lateral transistor.

On the other hand it is known to improve the · stability of differential amplifier by including in its signal path a so-called compensating capacitance which shifts the dominant pole of the amplifier in the direction of the lower frequencies and thereby decreases the frequency at unity gain of the amplifier.

Hence, by inserting the high voltage lateral transistor Q17 in the signal path of the amplifier a compensating effect is obtained just as if a compensating capacitance were used.

Because the amplification provided by the above described amplifier is relatively high, it might however still be necessary to use in addition to Q17 a compensating capacitance such as C1 connected between collector and base of Q20. Obviously, it can then advantageously be smaller than without transistor Q17.

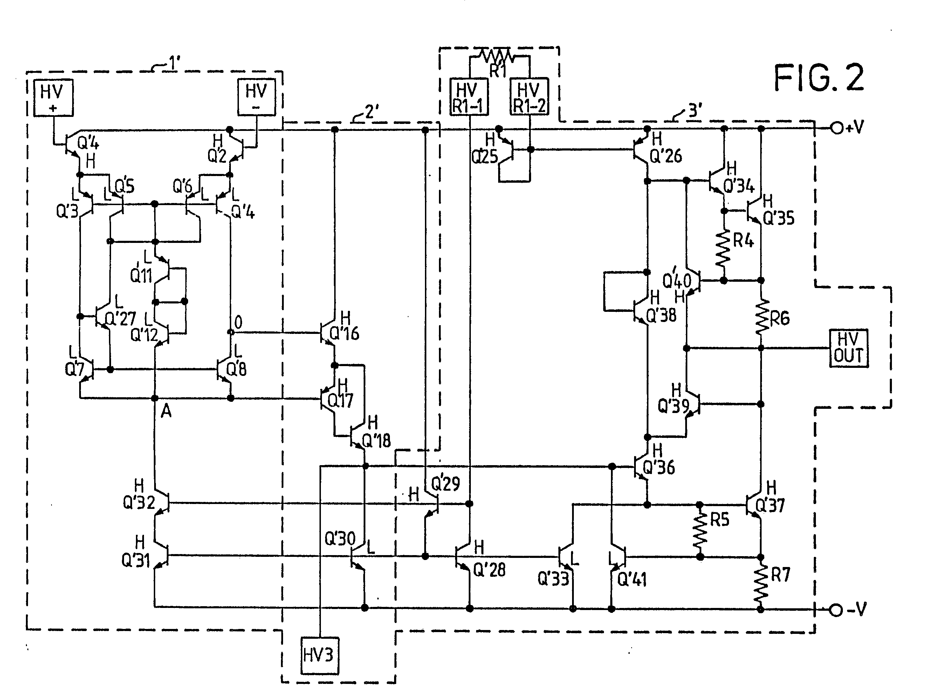

The operational amplifier shown in Fig. 2 is similar to that of Fig. 1 but configured to be more efficiently manufacturable on an integrated circuit chip. The square terminals HV illustrate bonding pads on a chip which uses bipolar technology. Components which have the same function as in Fig. 1 are designated by the same references, however provided with a prime.

This operational amplifier mainly differs from that of Fig. 1 in that:

— a single biasing circuit including transistors Q'25, Q'26, pad HV—R1—2, resistor R'1, pad HV—R1—1 and transistors Q'28 to Q33, all connected as shown, is used for biasing all three stages 1', 2' and 3';
— the current source active load of the input stage 1' now includes an additional transistor Q'27, whose base and emitter are respectively connected to the collector and base of Q'7 and whose collector is connected to the joined collectors and bases of Q'5 and Q'6;
— no use is made of an additional amplification stage Q9, Q10, Q15. Instead, the voltage between the collector and emitter of Q'8 is now directly applied between the bases of Q'16 and Q'17;
— no use is made of a transistor corresponding to Q19. Instead, the emitter of Q'18 is connected to −V via transistor Q'30 as shown, in parallel with the base-emitter junction of transistor Q'36 and resistors R5 and R7 all in series;
— no use is made of a transistor corresponding to Q20;
— use is made of a different output stage which is known in principle from pages 308—311 of the above mentioned book by P. R. Gray which on pages 313—316 also describes overload protection circuits.

This output stage includes NPN transistors Q'34 to Q'41. The base of Q'34 is connected to the collector of Q'26, this connection being comparable to the connection between Q21 and Q26 in Fig. 1. The emitter of Q'36 is connected to −V via current mirror transistor Q'33 and its base is connected to the emitter of transistor Q'18 of the intermediate stage 2'. The collector-emitter path of Q'35 is connected between +V and terminal OUT via overload protection resistor R6, whilst the collector-emitter path of transistor Q'37 is connected between this terminal OUT and −V via overload protection resistor R7. The collector-emitter path of Q'34 is connected in series with resistor R4 between +V and resistor R6, the emitter of Q'34 being connected to the base of Q'35. Terminal OUT and the junction point of the collector of Q'26 and the base of Q'34 are connected to the collector of Q'36 via diode connected transistors Q'39 and Q'38 respectively. The emitter of Q'36 is also connected to the base of Q'37. The collector-emitter path of overload protection transistor Q'40 is connected between the base of Q'34 and terminal OUT, the base of Q'40 being connected to the junction point of resistors R4 and R6. Likewise, the collector-emitter path of overload protection transistor Q'41 is connected between the base of Q'36 and −V, the base of Q'41 being connected to the junction point of resistors R5 and R7. The operation of this output stage is not described in detail since it is known from the book by P. R. Gray and without importance for the present invention.

In the above mentioned current source Q'25, Q'26, R'1, Q'28—Q'33, the function of Q'28, Q'29 and Q'30, Q'31, Q'33 is smaller to that of Q'7, Q'27 and Q'8 respectively. Without transistor Q'32 the collector voltage of Q'31 would follow that at the junction point A and the same would be true for the collector current because of the slope of the collector-emitter voltage versus collector current characteristic, i.e. because of the Early voltage. By the use of transistor Q'32 the collector of Q'31 is maintained at a fixed voltage equal to the fixed voltage at the base of Q'29 less the base-emitter voltage of Q'32 so that the collector current voltage of Q'31 is independent of the voltage variations at point A which is now only four emitter-base voltages below the input voltage because transistors Q9 and Q10 have been omitted.

While the principles of the invention have been described above in connection with specific apparatus, it is to be clearly understood that this description is made only by way of example and not as a limitation on the scope of the invention.

**Claims**

1. Differential amplifier with two signal branches each connected in series with a common current source between terminals of a power supply source and each having a signal input, characterized in that each of said signal branches (Q1/2, Q3/4, Q7/8, Fig. 1) and an associated parallel signal branch (Q1/2, Q5/6, Q9/10, Q11, Q12, Fig. 1) have a common portion constituted by the base-to-emitter junction of a respective high voltage transistor (Q1/2) whose base constitutes a respective signal input and whose collector is coupled to one (+V, Fig. 1) of said power supply terminals, said parallel signal branch having a low signal impedance as compared to that of said current source and being able to establish a substantially constant voltage between each of said inputs and the junction point (A) of said branches and said current source (Q14, Fig. 1).

2. Differential amplifier according to claim 1, characterized in that said current source includes a third high voltage transistor (Q14, Fig. 1).

3. Differential amplifier according to claim 1, characterized in that in each of said parallel signal branches said base-to-emitter junction is connected in series with diodes.

4. Differential amplifier according to claim 3, characterized in that in each of said signal branches the emitter of the high voltage transistor out of said pair (Q1/2, Fig. 1) is coupled to said junction point (A) via the series connection of the collector-emitter paths of a first (Q3/4, Fig. 1) and a second (Q7/8, Fig. 1) low voltage transistor, the bases of the first low voltage transistors (Q3/4) being interconnected and the second low voltage transistors (Q7/8, Fig. 1) being interconnected in current mirror configuration, and that in each of said parallel signal branches said base-to-emitter junction is connected in series with a diode connected third low voltage transistor (Q5/6, Fig. 1) and in common for the two parallel signal branches with diode connected fourth (Q11, Fig. 1) and fifth (Q12, Fig. 1) low voltage transistors, the bases of said third low voltage transistors (Q5/6, Fig. 1) being connected to those of said first low voltage transistors (Q3/4, Fig. 1) and their emitters to the respective emitters of said pair of high voltage transistors.

5. Differential amplifier according to claim 4, characterized in that said series connection of transistor base-emitter junctions further includes the base-emitter junction of a sixth low voltage transistor (Q9/10, Fig. 1), this base-emitter junction being connected between those of said third (Q5/6, Fig. 1) and fourth (Q11, Fig. 1) low voltage transistors, and one (Q9, Fig. 1) of the sixth low voltage transistors (Q9/10, Fig. 1) being diode connected and connected in current mirror configuration with the other sixth low voltage transistor (Q10, Fig. 1).

6. Differential amplifier according to claim 1, characterized in that it has a two-terminal output (O, A) with a first output terminal (O) on one of said signal branches and with a second output terminal (A) constituted by said junction point, said first (O) and second (A) output terminals being coupled to respective input terminals of a transducer (Q15, Q16, Q17, Q18, Fig. 1) able to transform a floating output signal appearing across said output terminals (O, A) into a non-floating output signal appearing across a third output terminal and a fourth output terminal constituted by one (−V) of said power supply source terminals.

7. Differential amplifier according to claims 4 and 6, characterized in that said first output terminal (O) is taken at the junction point of the collectors of said first (Q3/4, Fig. 1) and second (Q7/8, Fig. 1) low voltage transistors included in said one signal branch.

8. Differential amplifier according to claim 6, characterized in that said transducer includes at least a fourth (Q16, Fig. 1) and a fifth (Q17, Fig. 1) high voltage transistor the collector-emitter paths of which are coupled in series between the other terminal (+V) of said power supply source and said third output terminal which is coupled to said fourth output terminal via a low impedance (R3, Fig. 1).

9. Differential amplifier according to claims 5 and 8, characterized in that the base of said fourth high voltage transistor (Q16, Fig. 1) is connected to the common collectors of said other sixth low voltage transistor (Q10, Fig. 1) and of a seventh low voltage transistor (Q15, Fig. 1), the base and emitter of which are connected to said first (O) and second (A) output terminals respectively.

10. Differential amplifier according to claim 8, characterized in that said fifth high voltage transistor (Q17, Fig. 1) is a lateral transistor.

11. Differential amplifier according to claim 10, characterized in that each fifth high voltage transistor (Q17, Fig. 1) is a PNP transistor the emitter and collector of which are respectively connected to the collector and base of a sixth high voltage transistor (Q18, Fig. 1) which is an NPN transistor the emitter of which constitutes said third output terminal of said transducer.

12. Differential amplifier according to claim 10, characterized in that said fifth high voltage transistor (Q17) is included in the signal path between said signal inputs (+, −) and said third output terminal.

13. Differential amplifier according to claim 1, characterized in that said current source includes the series connection between said power supply terminal (+V, −V) of at least a resistor (R′1, Fig. 2) and the collector-emitter path of a seventh high voltage transistor (Q′28, Fig. 2) which is connected in current mirror configuration with at least an eighth high voltage transistor (Q′31, Fig. 2) and the collector of which is connected to the base of a ninth high voltage transistor (Q′29, Fig. 2) the collector-emitter path of which is connected between one terminal (+V) of said power supply source and the base of said seventh voltage transistor (Q′28, Fig. 2) and the base of which is connected to the base of said third high voltage transistor (Q′32, Fig. 2) the collector-emitter path of which is connected in series with the collector-emitter path of said eighth high voltage transistors (Q′31, Fig. 2) between said junction point (A) and the other terminal (−V) of said power supply source.

14. Differential amplifier according to claim 1, characterized in that it includes a signal path which extends from its inputs to its output and includes only one lateral transistor (Q17).

15. Differential amplifier according to claim 14, characterized in that said lateral transistor (Q17) is a high voltage transistor.

**Revendications**

1. Amplificateur différentiel à deux branches de signal dont chacune est reliée, en série, à une source de courant commune entre les bornes d'une source d'alimentation et ayant chacune une entrée de signal, caractérisé en ce que chacune desdites branches de signal (Q1/2, Q3/4, Q7/8, Fig. 1) et une branche de signal parallèle associée (Q1/2, Q5/6, Q9/10, Q11, Q12, Fig 1) ont une partie commune constituée par le trajet base-émetteur d'un transistor haute-tension (Q1/2) respectif dont la base constitue l'entrée de signal respective et dont le collecteur est relié à l'une (+V, Fig 1) des bornes de ladite source d'alimentation, ladite branche de signal parallèle ayant une impédance de signal faible par rapport à celle de ladite source de courant et étant capable d'établir une tension sensiblement constante entre chacune desdites entrées et le point de jonction (A) desdites branches et ladite source de courant (Q14, Fig. 1).

2. Amplificateur différentiel selon la revendication 1, caractérisé en ce que ladite source de courant comporte un troisième transistor haute tension (Q14, Fig. 1).

3. Amplificateur différentiel selon la revendication 1, caractérisé en ce que le trajet base-émetteur de chacune desdites branches de signal parallèles est montée en série avec des diodes.

4. Amplificateur différentiel selon la revendication 3, caractérisé en ce que dans chacune desdites branches de signal, l'émetteur de chacun de la paire de transistors haute-tension (Q1/2, Fig 1) est relié audit point de jonction (A) au travers du montage en série de trajets collecteur-émetteur d'un premier (Q3/4, Fig 1) et d'un second (Q7/8, Fig 1) transistor basse-tension, les bases desdits premiers transistors basse-tension (Q3/Q4) étant reliées entre elles, tandis que les seconds transistors basse-tension (Q7/8) sont couplés en configuration de miroir de courant, et en ce que dans chacune desdites branches de signal parallèles, ledit trajet base-émetteur est relié en série avec un troisième transistor basse-tension (Q5/6, Fig. 1) monté en diode et, en commun pour les deux branches de signal parallèles, avec des quatrième (Q11, Fig 1) et cinquième (Q12, Fig 1) transistors basse-tension montés en diodes, les bases desdits troisièmes transistors basse-tension Q5/6, Fig 1) étant reliées à celles desdits premiers transistors basse-tension (Q3/4, Fig 1) et leurs émetteurs aux émetteurs respectifs de ladite paire de transistors haute-tension.

5. Amplificateur différentiel selon la revendication 4, caractérisé en ce que ledit montage en série avec les trajets base-émetteur des transistors comprend de plus le trajet base-émetteur d'un sixième transitor basse-tension (Q9/10, Fig 1), ce trajet base-émetteur étant monté entre ceux desdits troisièmes (Q5/6, Fig 1) et quatrième (Q11, Fig 1) transistor basse-tension et en ce que l'un (Q9, Fig 1) desdits sixièmes transistors basse-tension est monté en diode et en configuration de miroir de courant avec l'autre sixième transistor basse-tension (Q10, Fig 1).

6. Amplificateur différentiel selon la revendication 1, caractérisé en ce qu'il possède une sortie à deux bornes (O, A), une première borne de sortie (O) sur l'une desdites branches de signal et une seconde borne de sortie (A) constituée par ledit point de jonction, lesdites première (O) et seconde (A) bornes de sortie étant reliées aux bornes d'entrée respectives d'un transducteur (Q15, Q16, Q17, Q18, Fig 1) capable de transformer un signal de sortie flottant apparaissant entre lesdites bornes de sortie (O, A) en un signal de sortie non-flottant apparaissant entre une troisième borne de sortie et une quatrième borne de sortie constituée par l'une (−V) desdites bornes de la source d'alimentation.

7. Amplificateur différentiel selon les revendications 4 et 6 caractérisé en ce que ladite première borne de sortie (O) est prise au point de jonction des collecteurs desdits premièrs (Q3/4, Fig 1) et seconds (Q7/8, Fig 1) transistors basse-tension faisant partie de ladite branche de signal.

8. Amplificateur différentiel selon la revendication 6, caractérisé en ce que ledit transducteur comporte au moins un quatrième (Q16, Fig. 1) et un cinquième (Q17, Fig 1) transistor haute-tension dont les trajets collecteur-émetteur sont montés en série entre l'autre borne (+V) de ladite source d'alimentation et ladite troisième borne de sortie qui est reliée à ladite quatrième borne de sortie par une impédance faible (R3, Fig 1).

9. Amplificateur différentiel selon les revendications 5 et 8, caractérisé en ce que la base dudit quatrième transistor haute-tension (Q16, Fig 1) est reliée aux collecteurs communs dudit autre sixième transistor basse-tension (Q10, Fig 1) et d'un septième transistor basse-tension (Q15, Fig 1), dont la base et l'émetteur sont reliés respectivement à ladite première (O) et à ladite seconde (A) borne de sortie.

10. Amplificateur différentiel selon la revendication 8, caractérisé en ce que ledit cinquième transistor haute-tension (Q17, Fig 1) est un transistor latéral.

11. Amplificateur différentiel selon la revendication 10, caractérisé en ce que chaque cinquième transistor haute-tension (Q17, Fig 1) est un transistor PNP dont l'émetteur et le collecteur sont reliés respectivement au collecteur et à base d'un sixième transistor haute-tension (Q18, Fig. 1) qui est un transistor NPN dont l'émetteur constitue ladite troisième borne de sortie dudit transducteur.

12. Amplificateur différentiel selon la revendication 10, caractérisé en ce que ledit cinquième transistor haute-tension (Q17) est monté sur le trajet de signal entre leddites entrées de signal (+, −) et ladite troisième borne de sortie.

13. Amplificateur différentiel selon la revendication 1, caractérisé en ce que ladite source de courant comporte, montés en série entre les bornes (+V, −V) de ladite source d'alimentation, au moins une résistance $R'_1$, Fig. 2) et le trajet collecteur-émetteur d'un septième transistor haute-tension (Q'28, Fig 2) qui est relié en configuration de miroir de courant avec au moins un huitième transistor haute-tension (Q'31, Fig 2) et dont le collecteur est relié à la base d'un neuvième transistor haute-tension (Q'29, Fig 2) dont le trajet collecteur-émetteur est branché entre une borne (+V) de ladite source d'alimentation et la base dudit septième transistor haute-tension (Q'28, Fig 2) et dont la base est reliée à la base dudit troisième transistor haute-tension (Q'32, Fig 2) dont le trajet collecteur-émetteur est monté en série avec le trajet collecteur-émetteur dudit huitième transistor haute-tension (Q'31, Fig 2) entre ledit point de jonction (A) et l'autre borne (−V) de ladite source d'alimentation.

14. Amplificateur différentiel selon la revendication 1, caractérisé en ce qu'il comporte un trajet de signal qui s'étend depuis ses entrées vers ses sorties et qui ne comporte qu'un seul transistor latéral (Q17).

15. Amplificateur différentiel selon la revendication 14, caractérisé en ce que ledit transistor latéral (Q17) est un transistor haute-tension.

## Patentansprüche

1. Differenzverstärker mit zwei jeweils in Reihe mit einer gemeinsamen Stromquelle zwischen Anschlußklemmen einer Stromversorgungsquelle liegenden und jeweils einen Signaleingang aufweisenden Signalweigen, dadurch gekennzeichnet, daß jeder der Signalzweige (Q1/2, Q3/4, Q7/8, Figur 1) und ein jeweils zugeordneter paralleler Signalzweig (Q1/2, Q5/6, Q9/10, Q11, Q12, Figur 1) einen gemeinsamen Teil aufweisen, der durch den Basis-Emitter-Übergang eines Hochspannungstransistors (Q1/2) gebildet ist, dessen Basis den jeweiligen Signaleingang bildet und dessen Kollektor an einer (+V, Figur 1) der Stromversorgungsanschlußklemmen liegt, wobei der parallele Signalzweig gegenüber der Stromquelle eine niedrige Signalimpedanz aufweist und zwischen jedem der Eingänge und dem Verbindungspunkt (A) der Zweige mit der Stromquelle (Q14, Figur 1) eine im wesentlichen konstante Spannung erzeugen kann.

2. Differenzverstärker nach Anspruch 1, dadurch gekennzeichnet, daß die Stromquelle einen dritten Hochspannungstransistor Q14, Figur 1) enthält.

3. Differenzverstärker nach Anspruch 1, dadurch gekennzeichnet, daß in jedem der parallelen Signalzweige der Basis-Emitter-Übergang in Reihe mit Dioden liegt.

4. Differenzverstärker nach Anspruch 3, dadurch gekennzeichnet, daß in jedem der Signalzweige der Emitter des Hochspannungstransistors (Q1/2, Figur 1) über die Reihenschaltung der Kollektor-Emitter-Strecken eines ersten (Q3/4, Figur 1) und eines zweiten (Q7/8, Figur 1) Niederspannungstransistor an den Verbindungspunkt (A) angeschlossen ist, wobei die Basen der ersten Niederspannungstransistoren (Q3/4) zusammengeschaltet und die zweiten Niederspannungstransistoren (Q7/8, Figur 1) in einer Stromspiegelkonfiguration angeordnet sind, und daß in jedem der parallelen Signalzweige der Basis-Emitter-Übergang in Reihe mit einem als Diode geschalteten Niederspannungstransistor (Q5/6, Figur 1) und gemeinsam für die beiden parallelen Signalzweige mit einem als Diode geschalteten vierten (Q11, Figur 1) und einem fünften (Q12, Figur 1) Niederspannungstransistor liegt, wobei die Basen der dritten Niederspannungstransistoren (Q5/6, Figur 1) an die der ersten Niederspannungstransistoren (Q3/4, Figur 1) und ihre Emitter an die jeweiligen Emitter des Hochspannungstransistorpaars angeschlossen sind.

5. Differenzverstärker nach Anspruch 4, dadurch gekennzeichnet, daß die aus Transistor-Basis-Emitter-Übergängen bestehende Reihenschaltung außerdem den Basis-Emitter-Übergang eines sechsten Niederspannungstransistors (Q9/10, Figur 1) enthält, wobei dieser Basis-Emitter-Übergang zwischen den Basis-Emitter-Übergängen des dritten (Q5/6, Figur 1) und des vierten (Q11, Figur 1) Niederspannungstransistors liegt und einer (Q9, Figur 1) der sechsten Niederspannungstransistoren (Q9/10, Figur 1) als Diode geschaltet und zusammen mit dem anderen sechsten Niederspannungstransistor (Q10, Figur 1) in einer Stromspiegelkonfiguration angeordnet ist.

6. Differenzverstärker nach Anspruch 1, dadurch gekennzeichnet, daß er einen aus zwei Klemmen (O, A) bestehenden Ausgang aufweist, von denen die erste Ausgangsklemme (O) an einen der Signalzweige angeschlossen ist und die zweite Ausgangsklemme (A) durch den Verbindungspunkt gebildet ist, wobei die erste (O) und die zweite (A) Ausgangsklemme an die jeweiligen Eingangsklemmen eines Wandlers (Q15, Q16, Q17, Q18, Figur 1) angeschlossen sind, welcher in der Lage ist, ein an den Ausgangsklemmen (O, A) erscheinendes schwebendes Ausgangssignal in ein nicht schwebendes Ausgangssignal umzuwandeln, das von einer dritten Ausgangsklemme und einer vierten, von einer (−V) der Stromversorgungsanschluß-Klemmen gebildeten Klemme abgreifbar ist.

7. Differenzverstärker nach den Ansprüchen 4 und 6, dadurch gekennzeichnet, daß die erste Ausgangsklemme (O) durch den Verbindungspunkt der Kollektoren der ersten (Q3/4, Figur 1) und zweiten (Q7/8, Figur 1) im jeweiligen Signalzweig enthaltenen Niederspannungstransistoren gebildet ist.

8. Differenzverstärker nach Anspruch 6, dadurch gekennzeichnet, daß der Wandler mindestens einen vierten (Q16, Figur 1) und einen fünften (Q17, Figur 1) Hochspannungstransistor enthält, deren Kollektor-Emitter-Strecken in Reihe zwischen der anderen Anschlußklemme (+V) der Stromversorgungsquelle und der dritten Ausgangsklemme liegen, die über eine kleine Impedanz (R3, Figur 1) mit der vierten Ausgangsklemme verbunden ist.

9. Differenzverstärker nach den Ansprüchen 5 und 8, dadurch gekennzeichnet, daß die Basis des vierten Hochspannungstransistors (Q16, Figur 1) mit den Kollektoren des anderen sechsten Niederspannungstransistors (Q10, Figur 1) und eines siebten Niederspannungstransistors (Q15, Figur 1) verbunden ist, dessen Basis an der ersten Ausgangsklemme (O) und dessen Emitter an der zweiten Ausgangsklemme (A) liegen.

10. Differenzverstärker nach Anspruch 8, dadurch gekennzeichnet, daß der fünfte Hochspannungstransistor (Q17, Figur 1) ein lateraler Transistor ist.

11. Differenzverstärker nach Anspruch 10, dadurch gekennzeichnet, daß jeder der fünften Hochspannungstransistoren (Q17, Figur 1) ein PNP-Transistor ist, dessen Emitter an den Kollektor und dessen Kollektor an die Basis eines sechsten Hochspannungstransistors (Q18, Figur 1) angeschlossen sind, welcher ein NPN-Transistor ist, dessen Emitter die dritte Ausgangsklemme des Wandlers bildet.

12. Differenzverstärker nach Anspruch 10, dadurch gekennzeichnet, daß der fünfte Hochspannungstransistor (Q17) im Signalweg zwischen den Signaleingängen (+, −) und der dritten Ausgangsklemme liegt.

13. Differenzverstärker nach Anspruch 1, dadurch gekennzeichnet, daß die Stromquelle eine zwischen den Stromversorgungsanschlußklemmen (+V, −V) liegende Reihenschaltung aus mindestens einem Widerstand (R'1, Figur 2) und der Kollektor-Emitter-Strecke eine siebten Hochspannungstransistors (Q'28, Figur 2) enthält, der zusammen mit mindestens einem achten Hochspannungstransistor Q'31, Figur 2) in einer Stromspiegelkonfiguration angeordnet ist und dessen Kollektor mit der Basis eines neunten Hochspannungstransistors (Q'29, Figur 2) verbunden ist, dessen Kollektor-Emitter-Strecke zwischen einer Anschlußklemme (+V) der Stromversorgungsquelle und der Basis des siebten Hochspannungstransistors (Q'28, Figur 2) liegt, und dessen Basis mit der Basis des dritten Hochspannungstransistors (Q'32, Figur 2) verbunden ist, dessen Kollektor-Emitter-Strecke in Reihe mit der Kollektor-Emitter-Strecke des achten Hochspannungstransistors (Q'31, Figur 2) zwischen dem Verbindungspunkt (A) und der anderen Anschlußklemme (−V) der Stromversorgungsquelle liegt.

14. Differenzverstärker nach Anspruch 1, dadurch gekennzeichnet, daß er einen von seinen Eingängen zu seinen Ausgängen verlaufenden Signalweg aufweist, der nur einen lateralen Transistor (Q17) enthält.

15. Differenzverstärker nach Anspruch 14, dadurch gekennzeichnet, daß der lateral Transistor (Q17) ein Hochspannungstransistor ist.

FIG.1

0 074 680

FIG.2

0 074 680